# EUROPEAN PATENT SPECIFICATION

(11) **EP 2 214 304 B1**
(45) Date of publication and mention of the grant of the patent: **12.10.2011**
(21) Application number: 09001271.7
(22) Date of filing: 30.01.2009
(51) Int. Cl.: H03F 1/02, H03K 3/3565

(54) **Switch mode assisted linear amplifier for baseband signal amplification**
Getakteter Linearverstärker für Basisbandsignalverstärkung
Amplificateur linéaire assisté par mode de commutation pour amplification de signal à large bande

(43) Date of publication of application: 04.08.2010
(73) Proprietor: Alcatel Lucent, 75007 Paris (FR)
(72) Inventor: Machinal, Robin, 70173 Stuttgart (DE); Luz, Gerhard, 74321 Bietigheim-Bissingen (DE); Wiegner, Dirk, 71409 Schwaikheim (DE)
(74) Representative: Schmidt, Werner Karl

(56) References cited:
- EP-A- 0 082 282
- US-A1- 2007 285 291
- US-B1- 6 300 826
- US-B1- 6 710 646

## Description

### Background of the Invention

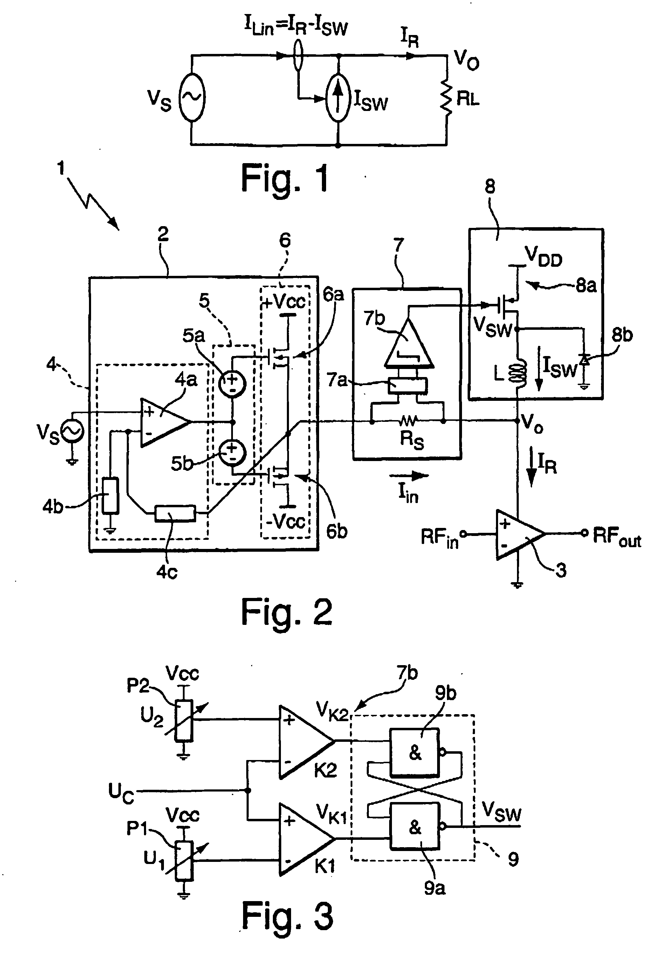

The invention relates to a Switch Mode Assisted Linear Amplifier, SMALA, for amplification of a baseband input signal, comprising: a linear stage adapted to perform linear amplification of the baseband input signal, a hysteretic control stage for generating a pulse-width modulated signal from a current produced by the linear stage, and a switching stage adapted to amplify the pulse-width modulated signal to generate a further current which is added to the current of the linear stage. The invention also relates to an Envelope tracking, ET, or Envelope Elimination and Restoration, EER, amplifier unit, to a base station and to a radio network comprising such a SMALA. A Switch Mode Assisted Linear Amplifier, in the following referred to as SMALA, combines a linear amplifier stage with a switch-mode amplifier stage. The underlying concept of the SMALA will be shortly explained in the following with reference to **Fig. 1****,** showing a baseband input signal **Vₛ** which is amplified in a linear amplifier stage, thus generating an output voltage **V₀,** provided as a supply voltage to a load **R_{L}.** The linear amplifier stage, however, typically only supplies a fraction Iₗᵢₙ of the full load current I_{R} to the load R_{L}. Thus, a switch-mode amplifier stage is operated in parallel with the linear amplifier stage to supply the full load current I_{R} to the load R_{L}. For this purpose, the switching stage generates a further (switching) current I_{sw} which is derived from the current Iₗᵢₙ produced by the linear stage and is added to the linear current Iₗᵢₙ.

For performing current control, the current of the linear stage is sensed with a sense resistor, the current flowing through the resistor generating a control voltage which is amplified by a difference amplifier and fed to a Schmitt-Trigger of the hysteretic stage which controls the switching stage of the SMALA.

The load which is connected to the SMALA may be an RF amplifier, in particular used in an envelope tracking (ER) or envelope elimination and restoration (EER) amplifier unit. Such ER or EER units have to deal with more and more complex modulation schemes being used in modem mobile communications systems. For radio applications, the SMALA has to provide an adaptive supply voltage to the drain of the RF amplifier over a baseband frequency range from DC up to tens of MHz. Thus, in order to provide high system linearity and efficiency, the SMALA should be as precise as possible over the entire amplified baseband frequency range.

US 6,300,826 B1 discloses an implementation of a SMALA for an ET modulator. The solution described therein is based on a comparator / hysteretic control stage with a network of three resistors with a positive feedback. However, such a solution is not satisfying regarding precision and thus linearity of the SMALA, as the hysteretic window thus obtained is not constant over the baseband frequency range and does not have a well-defined hysteretic window shape. Due to this, random switching of the switching stage cannot be fully prevented, leading to a sub-optimal performance of the switching stage, thus reducing the ET modulator's overall linearity.

### Object of the Invention

It is the object of the invention to improve linearity and efficiency of a SMALA for baseband input signals, i.e. for signals having a large amplified frequency range.

### Summary of the Invention

One aspect of the invention is implemented in a SMALA as described in the introduction, wherein the hysteretic control stage comprises a high-precision Schmitt trigger with two high-speed comparators, preferably having a rise time of less than ten nanoseconds, and with a RS flip-flop for generating a pulse-width modulated signal which is well-defined over the entire amplified baseband frequency range.

The inventors propose an improved hysteretic stage based on two very high-speed comparators and an RS flip-flop for proper switching between two thresholds, thus defining a well-shaped hysteretic window over the entire amplified baseband range. In contrast thereto, a conventional Schmitt-trigger (a comparator with positive feedback) lacks precision due to the fact that the trigger levels depend on the output voltages which are also not well-defined. It will be understood that for the applications described herein, the rise time of the components of the Schmitt-trigger have to be very small, typically 10 ns or less. In one embodiment, the RS flip-flop comprises two high-speed NAND-gates, preferably having a rise time of less than ten nanoseconds. When implementing the RS flip-flop by using two NAND-gates, the rise time of the NAND-gates should not exceed 10 ns for precisely defining the hysteretic window.

In another embodiment, the high-precision Schmitt trigger further comprises two adjustable voltage references, in particular potentiometers, which may be used to set the switching levels of the hysteretic stage.

For the applications described herein, typically the linear stage comprises a class-AB amplifier, preferably a multistage class-AB amplifier for increasing power capability and linearity of the amplification. In the multistage case, the linear stage may comprise a differential amplifier stage, a driver stage, and an output stage. In particular, the output stage of the linear stage may comprise at least one N-channel field effect transistor and at least one P-channel field effect transistor. A linear stage having such a dual feedback topolgy is described e.g. in US Patent Publication 2003/0137344 A1.

In a further embodiment, the hysteretic control stage comprises a resistor and a wideband current sensor for precisely and accurately measuring the current produced by the linear stage. A differential amplifier is then used to perform the conversion of the measured current into a (proportional) voltage which is then fed to the two comparators of the hysteretic stage.

In another advantageous embodiment, the switching stage is a class D amplifier stage which comprises an output stage and a low-pass filter. The output stage may comprise at least one field effect transistor and at least one diode (free-wheeling Schottky diode) being connected in series, the low-pass filter preferably being connected to the output stage. It will be understood that alternatively, the output stage may comprise two (or more) field effect transistors, a diode not being required in this case. The person skilled in the art will appreciate that the low-pass filter may comprise more than one inductance and, as the case may be, also one or more capacitors.

A further aspect of the invention is implemented in an Envelope Tracking, ET, or Envelope Elimination and Restoration, EER, amplifier unit, comprising: a RF power amplifier, and a Switch Mode Assisted Linear Amplifier, SMALA, for providing an adaptive supply voltage to the RF power amplifier, thus improving performance of the ET or EER modulator / amplifier and the ET or EER overall system, respectively, ET or EER amplifier units comprising a SMALA as described above may be deployed in base stations of radio networks, in particular in active antenna elements, power amplifier modules, or remote radio heads thereof. By using the improved SMALA technology as described above, even RF signals with complex modulation schemes may be amplified with high linearity and efficiency.

Further features and advantages are stated in the following description of exemplary embodiments, with reference to the figures of the drawing, which shows significant details, and are defined by the claims. The individual features can be implemented individually by themselves, or several of them can be implemented in any desired combination.

### Brief Description of the Drawings

Exemplary embodiments are shown in the diagrammatic drawing and are explained in the description below. The following are shown:
- **Fig. 1**: a schematic diagram for explaining the operation principle of a SMALA,
- **Fig. 2**: a circuit diagram of an embodiment of the SMALA according to the invention,
- **Fig. 3**: a circuit diagram of an embodiment of a hysteretic control stage of the SMALA of Fig. 2,
- **Fig. 4**: a hysteretic window generated by the hysteretic control stage of Fig. 3, and
- **Figs. 5a,b**: an EER amplifier unit and an ET amplifier, unit, respectively, comprising the SMALA of Fig. 2.

### Detailed Description of Preferred Embodiments

**Fig. 2** shows a circuit diagram representing the overall structure of a Switch Mode Assisted Linear Amplifier **1,** in the following referred to as SMALA. The SMALA 1 is used for amplifying a baseband input voltage signal Vₛ which covers a frequency range from typically DC to several MHz.

For this purpose, the SMALA 1 comprises a linear stage **2** which performs linear amplification of the baseband input signal Vₛ, producing an output voltage signal V₀ which constitutes an adaptive supply voltage for an RF power amplifier **3,** being used as the load of the SMALA 1. The RF power amplifier 3 amplifies an RF input signal RFᵢₙ to produce an amplified RF output signal RFₒᵤₜ which will be transmitted in a way explained further below.

The linear amplifier stage 2 is implemented as a multi-stage class-AB amplifier, comprising a differential amplifier stage **4** with a differential amplifier **4a** and two resistors **4b, 4c,** a driver stage **5,** and an output stage **6.** The output of the differential amplifier 4a is connected to two driving units **5a, 5b** of the driver stage 5, serving to drive and bias a N-channel field effect transistor **6a** and a P-channel field effect transistor **6b,** respectively. The field effect transistors **6a, 6b** are driven as an amplifier (source follower) by the respective driving stages **5a,** 5b. The output of the linear stage 2 is connected to the hysteretic control stage 7.

The SMALA 1 further comprises a hysteretic control stage **7** with a resistor **Rₛ** and a wideband current sensor **7a,** the resistor Rs and the sensor 7a being used for measuring the current Iₗᵢₙ produced by the linear stage 2. The wideband current sensor **7a** further comprises a differential amplifier (not shown) for converting the measured current Iₗᵢₙ to an input voltage **U_{c}** being proportional to the measured current Iₗᵢₙ, and being provided as an input to a high-precision Schmitt-Trigger **7b** for generating a pulse-width modulated signal **V_{sw}.** The pulse-width modulated signal V_{sw} is then provided to the gate of a field effect transistor **8a** (N-MOSFET) of a switching stage **8,** via a suitable gate driver (not shown) like the ISL2111 from Intersil.

The switching stage 8 further comprises a Schottky-diode **8b** which is connected in series to the field effect transistor **8a,** these two components forming an output stage 8a, 8b. An inductance **L** serving as a low-pass filter is connected in parallel to the diode 8b, the output stage 8a, 8b together with the inductance L forming a class D amplifier stage for amplifying the pulse-width modulated output signal V_{sw} from the hysteretic control stage 7 in order to produce a further current I_{sw} as an output signal which is added to the current Iₗᵢₙ of the linear stage 2 to produce the overall load current I_{R} for the RF amplifier 3.

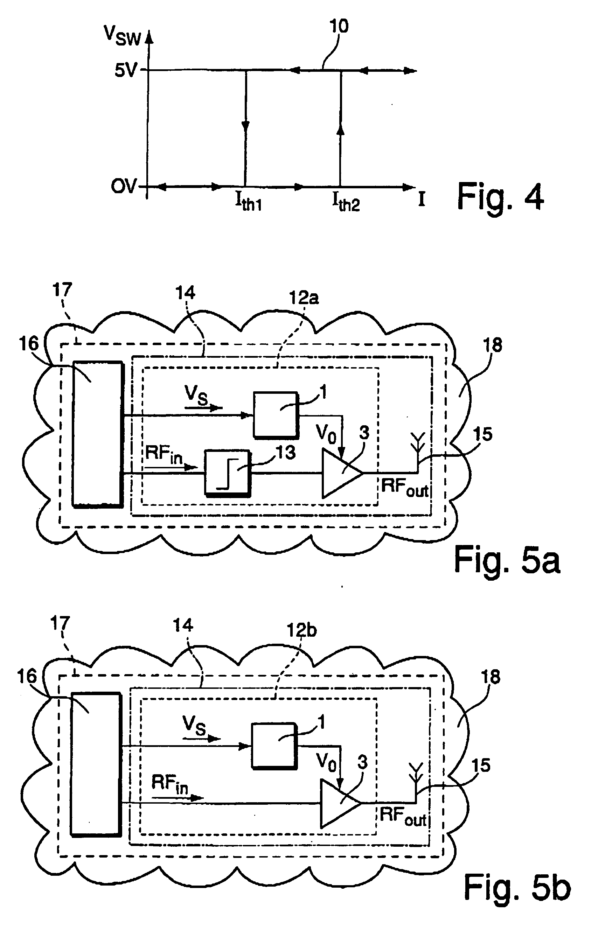

In the following, the implementation of the high-precision Schmitt-trigger 7b of the hysteretic control stage 7 will be explained with reference to **Fig. 3****.** The Schmitt-trigger 7b comprises two high-speed comparators **K1, K2** having a rise time of less than ten nanoseconds with a rail-to-rail output, e.g. LT1711 or LT!13 or LT1719 from linear technology. The input voltage U_{c} is provided as an input signal to both the first and second comparator K1, K2, a further input of the comparators K1, K2 being connected to a respective potentiometer **P1, P2,** serving as an adjustable voltage reference / voltage threshold, corresponding to a respective current threshold Iₜₕ₁ and Iₜₕ₂ for the current Iₗᵢₙ of the linear stage 2, cf. **Fig. 4****.**

The binary output signals **V_{K1}, V_{K2}** of the comparators K1, K2 are then fed to a common RS flip-flop **9** which is implemented using two NAND-gates **9a, 9b** having a rise time of less than ten nanoseconds with a rail-to-rail output, for example LT1711 or LT!13 or LT1719 from linear technology. In dependence of the (binary) output signals V_{K1}, V_{K2} of the comparators K1, K2, the following truth table may be derived:

| V_{K2} | V_{K1} | OUT | /OUT |
|---|---|---|---|
| 0 | 0 | /Q | Q |
| 0 | 1 | 0 | 1 |
| 1 | 0 | 1 | 0 |
| 1 | 1 | Q | /Q |

Thus, due to the high-speed components K1, K2, 9a, 9b, the hysteretic control stage 7 produces a hysteretic window **10** (see Fig. 4) which is well-defined over the entire amplified frequency band. In particular, the window width, i.e. the distance between Iₜₕ₁ and Iₜₕ₂, is (almost) constant over the entire frequency range from 0 Hz to hundreds of KHz. As can also be seen from Fig. 4, the output signal V_{sw} oscillates between a logical 1 (5 V in the present example), and a logical 0 (e.g. 0 V).

The person skilled in the art will appreciate that both the linear (class A, resp. class AB) amplifier stage 2 and the (class D) switching stage 8 may also be implemented in a different way. For example, in the switching stage 8, a filter comprising multiple inductances and capacitances may be used. Moreover, the output stage **8a, 8b** may be implemented by using two (or more) field effect transistors (N-MOSFETs) instead of one field effect transistor 8a and one diode 8b.

In any case, by using the high-precision Schmitt-trigger 7b for the hysteretic control stage 7 of the SMALA 1, the overall performance of the RF amplifier 3, in particular its linearity, can be improved. This is particularly advantageous when the RF amplifier 3 and the SMALA 1 are implemented in an ET or EER amplifier unit **12a, 12b** which are represented in **Fig. 5a** and **Fig. 5b****,** respectively.

The EER amplifier unit **12a** shown in Fig. 5a comprises the SMALA 1 of Fig. 2 which is used as an EER modulator for providing an adaptive supply voltage V₀ to the RF power amplifier 3, the adaptive supply voltage V₀ being based on the envelope signal Vₛ which is derived either directly from a digital signal processing unit via a suitable digital to analog converter and interface adaptation network (not shown), or from the RF output signal RFₒᵤₜ in an envelope detector (not shown), the RF input signal RFᵢₙ being is provided to the RF power amplifier 3 via a limiter **13.** The RF amplifier is then e.g. being realised in class-E or class-F operation mode.

Alternatively, the SMALA 1 may be used in the ET amplifier unit 12b shown in Fig. 5b. In this case, the RF power amplifier is used as a class-A/B amplifier, i.e. not as a switch, such that no limiter is required. The adaptive supply voltage V₀ is also generated in the SMALA 1, which is used as an ET modulator in this case. The envelope signal Vₛ of the modulator can again be derived either directly from a digital signal processing unit via a suitable digital to analog converter and interface adaptation network (not shown), or from the RF input signal Rfᵢₙ in an envelope detector (not shown).

The EER or ET amplifier units 12a, 12b may be part of an active antenna element **14** which provides the amplifier RF signal RFₒᵤₜ to an antenna **15** for radio transmission. Both the envelope signal Vₛ and the RF input signal RFᵢₙ may be provided to the EER or ET amplifier unit 12a, 12b by a baseband part **16** of a transmit frontend of a base station **17** which is itself part of a radio network **18.** The antenna element 15 may constitute one of a plurality of antenna elements (not shown) being connected to the baseband part 16 of the base station 17. The person skilled in the art will appreciate that instead of generating the envelope signal Vₛ in the baseband part 16, it may also be derived from the RF input signal RFₒᵤₜ in the EER or from the RF input signal RFᵢₙ in the ET amplifier unit **12a, 12b,** e.g. by using a tap coupler and an envelope detector.

The above description of the preferred embodiments has been given by way of example. From the disclosure given, those skilled in the art will not only understand the present invention and its attendant advantages, but will also find apparent various changes and modifications to the structures and methods disclosed. The applicant seeks, therefore, to cover all such changes and modifications as defined by the appended claims, and equivalents thereof.

## Claims

1. A Switch Mode Assisted Linear Amplifier (1), SMALA, for amplification of a baseband input signal (Vₛ), comprising:
a linear stage (2) adapted to perform linear amplification of the baseband input signal (Vₛ),
a hysteretic control stage (7) for generating a pulse-width modulated signal (V_{sw}) from a current (Iₗᵢₙ) produced by the linear stage (2), and
a switching stage (8) adapted to amplify the pulse-width modulated signal (V_{sw}) to generate a further current (I_{sw}) which is added to the current (Iₗᵢₙ) of the linear stage (2),
**characterized in that**
the hysteretic control stage (7) comprises a high-precision Schmitt trigger (7b) with two high-speed comparators (K1, K2), preferably having a rise time of less than ten nanoseconds, and with a RS flip-flop (9) for generating a pulse-width modulated signal (V_{sw}) which is well-defined over the entire amplified baseband frequency range.

2. SMALA according to claim 1, wherein the RS flip-flop (9) comprises two high-speed NAND-gates (9a, 9b), preferably having a rise time of less than ten nanoseconds.

3. SMALA according to claim 1, wherein the high-precision Schmitt trigger (7b) further comprises two adjustable voltage references (P1, P2).

4. SMALA according to claim 1, wherein the linear stage (2) is implemented as a multistage class-AB amplifier.

5. SMALA according to claim 4, wherein the linear stage (2) comprises a differential amplifier stage (4), a driver stage (5), and an output stage (6).

6. SMALA according to claim 5, wherein the output stage (6) comprises at least one N-channel field effect transistor (6a) and at least one P-channel field effect transistor (6b).

7. SMALA according to claim 1, wherein the hysteretic control stage (7) comprises a resistor (Rₛ) and a wideband current sensor (7a) for measuring the current (Iₗᵢₙ) produced by the linear stage (2).

8. SMALA according to claim 1, wherein the switching stage (8) is a class D amplifier stage which comprises an output stage (8a, 8b) and a low-pass filter (L).

9. SMALA according to claim 8, wherein the output stage (8a, 8b) comprises a field effect transistor (8a) and at least one diode (8b) connected in series.

10. SMALA according to claim 8, wherein the low-pass filter (L) is connected to the output stage (8a, 8b).

11. Envelope Tracking, ET, or Envelope Elimination and Restoration, EER, amplifier unit (12a, 12b) comprising:
a RF power amplifier (3), and
a Switch Mode Assisted Linear Amplifier (1), SMALA, according to claim 1 for providing an adaptive supply voltage (V₀) to the RF power amplifier (3).

12. Base station (17) comprising at least one ET or EER amplifier unit (12a, 12b) according to claim 11.

13. Base station according to claim 12, wherein the ET or EER amplifier unit (12a, 12b) is arranged in at least one of an in an active antenna element (14), a power amplifier module, and a remote radio head of the base station (17).

14. Radio network (18) comprising at least one base station (17) according to claim 12.

## Patentansprüche

1. Getakteter Linearverstärker (1), SMALA, für die Verstärkung eines Basisband-Eingangssignals (Vₛ), umfassend:
Eine lineare Stufe (2), ausgelegt für das Ausführen einer linearen Verstärkung des Basisband-Eingangssignals (Vₛ),
eine hysteretische Steuerstufe (7) zum Erzeugen eines pulsweitenmodulierten Signals (V_{sw}) aus einem von der linearen Stufe (2) erzeugten Strom (Iₗᵢₙ), und
eine Schaltstufe (8), ausgelegt für die Verstärkung des pulsweitenmodulierten Signals (V_{sw}), um einen weiteren Strom (I_{sw}), zu erzeugen, welcher mit dem Strom (Iₗᵢₙ) der linearen Stufe (2) addiert wird,
**dadurch gekennzeichnet, dass**
die hysteretische Steuerstufe (7) einen hochpräzisen Schmitt-Trigger (7b) mit zwei Hochgeschwindigkeitskomparatoren (K1, K2), vorzugsweise mit einer Anstiegszeit von weniger als zehn Nanosekunden, und mit einem RS-Flip-Flop (9) zum Erzeugen eines pulsweitenmodulierten Signals (V_{sw}), welches über den gesamten verstärkten Basisband-Frequenzbereich definiert ist, umfasst.

2. SMALA nach Anspruch 1, wobei das RS-Flip-Flop (9) zwei Hochgeschwindigkeits-NAND-Gates (9a, 9b), vorzugsweise mit einer Anstiegszeit von weniger als zehn Nanosekunden, umfasst.

3. SMALA nach Anspruch 1, wobei der hochpräzise Schmitt-Trigger (7b) weiterhin zwei einstellbare Spannungsreferenzen (P1, P2) umfasst.

4. SMALA nach Anspruch 1, wobei die lineare Stufe (2) als ein mehrstufiger Klasse-AB-Verstärker implementiert wird.

5. SMALA nach Anspruch 4, wobei die lineare Stufe (2) eine Differenzverstärkerstufe (4), eine Treiberstufe (5), und eine Ausgangsstufe (6) umfasst.

6. SMALA nach Anspruch 5, wobei die Ausgangsstufe (6) mindestens einen n-Kanal-Feldeffekttransistor (6a) und mindestens einen p-Kanal-Feldeffekttransistor (6b) umfasst.

7. SMALA nach Anspruch 1, wobei die hysteretische Steuerstufe (7) einen Widerstand (Rₛ) und einen Breitband-Stromsensor (7a) zum Messen des in der linearen Stufe (2) erzeugten Stroms (Iₗᵢₙ) umfasst.

8. SMALA nach Anspruch 1, wobei die Schaltstufe (8) eine Klasse-D-Verstärkerstufe ist, welche eine Ausgangsstufe (8a, 8b) und einen Tiefpassfilter (L) umfasst.

9. SMALA nach Anspruch 8, wobei die Ausgangsstufe (8a, 8b) einen Feldeffekttransistor (8a) und mindestens eine Diode (8b) in Reihenschaltung umfasst.

10. SMALA nach Anspruch 8, wobei der Tiefpassfilter (L) an die Ausgangsstufe (8a, 8b) angeschlossen ist.

11. Hüllkurvennachführungs-, ET, oder Hüllkurvenentfernungs- und wiederherstellungs-, EER, -Verstärkereinheit (12a, 12b), umfassend:
Einen RF-Leistungsverstärker (3), und
einen getakteten Linearverstärker (1), SMALA, gemäß Anspruch 1 zur Bereitstellung einer adaptiven Versorgungsspannung (Vₒ) an den RF-Leistungsverstärker (3).

12. Basisstation (17) mit mindestens einer ET- oder EER-Verstärkereinheit (12a, 12b) gemäß Anspruch 11.

13. Basisstation nach Anspruch 12, wobei die ET- oder EER-Verstärkereinheit (12a, 12b) in zumindest entweder einem aktiven Antennenelement (14), einem Leistungsverstärkermodul oder einem entfernten Funkkopf der Basisstation (17) angeordnet ist.

14. Funknetzwerk (18) mit mindestens einer Basisstation (17) gemäß Anspruch 12.

## Revendications

1. Amplificateur linéaire assisté par mode de commutation (1), SMALA, pour l'amplification d'un signal d'entrée en bande de base (Vₛ), comprenant ;
un étage linéaire (2) adapté pour effectuer une amplification linéaire du signal d'entrée en bande de base (Vₛ),
un étage de commande hystérétique (7) pour générer un signal à modulation de largeur d'impulsion (V_{sw}) à partir d'un courant (Iₗᵢₙ) produit par l'étage linéaire (2), et un étage de commutation (8) adapté pour amplifier le signal à modulation de largeur d'impulsion (V_{sw}) pour générer un autre courant (I_{sw}) qui est ajouté au courant (Iₗᵢₙ) de l'étage linéaire (2),
**caractérisé en ce que**
l'étage de commande hystérétique (7) comprend une bascule de Schmitt de haute précision (7b) avec deux comparateurs haute vitesse (K1, K2), ayant de préférence un temps de montée inférieur à dix nanosecondes, et avec une bascule bistable RS (9) pour générer un signal à modulation de largeur d'impulsion (V_{sw}) qui est bien défini sur l'ensemble de la plage amplifiée de fréquences de bande de base.

2. SMALA selon la revendication 1, dans lequel la bascule bistable RS (9) comprend deux portes NON-ET haute vitesse (9a, 9b), ayant de préférence un temps de montée inférieur à dix nanosecondes.

3. SMALA selon la revendication 1, dans lequel la bascule de Schmitt de haute précision (7b) comprend en outre deux références de tension ajustables (P1, P2).

4. SMALA selon la revendication 1, dans lequel l'étage linéaire (2) est mis en oeuvre comme un amplificateur de classe AB à plusieurs étages.

5. SMALA selon la revendication 4, dans lequel l'étage linéaire (2) comprend un étage d'amplificateur différentiel (4), un étage d'attaque (5) et un étage de sortie (6).

6. SMALA selon la revendication 5, dans lequel l'étage de sortie (6) comprend au moins un transistor à effet de champ à canal N (6a) et au moins un transistor à effet de champ à canal P (6b).

7. SMALA selon la revendication 1, dans lequel l'étage de commande hystérétique (7) comprend une résistance (Rₛ) et un capteur de courant à large bande (7a) pour mesurer le courant (Iₗᵢₙ) produit par l'étage linéaire (2).

8. SMALA selon la revendication 1, dans lequel l'étage de commutation (8) est un étage d'amplificateur de classe D qui comprend un étage de sortie (8a, 8b) et un filtre passe-bas (L).

9. SMALA selon la revendication 8, dans lequel l'étage de sortie (8a, 8b) comprend un transistor à effet de champ (8a) et au moins une diode (8b) connectés en série.

10. SMALA selon la revendication 8, dans lequel le filtre passe-bas (L) est connecté à l'étage de sortie (8a, 8b).

11. Unité d'amplification de suivi d'enveloppe, ET, ou à élimination et restauration d'enveloppe, EER (12a, 12b) comprenant :
un amplificateur de puissance RF (3), et
un amplificateur linéaire assisté par mode de commutation (1), SMALA, selon la revendication 1 pour fournir une tension d'alimentation adaptative (Vₒ) à l'amplificateur de puissance RF (3).

12. Station de base (17) comprenant au moins une unité d'amplification ET ou EER (12a, 12b) selon la revendication 11.

13. Station de base selon la revendication 12, dans laquelle l'unité d'amplification ET ou EER (12a, 12b) est disposée dans au moins un élément parmi un élément d'antenne actif (14), un module d'amplificateur de puissance, et une tête radio distante de la station de base (17).

14. Réseau radio (18) comprenant au moins une station de base (17) selon la revendication 12.
